# EUROPÄISCHE PATENTSCHRIFT

(11) **EP 1 794 218 B1**
(45) Veröffentlichungstag und Bekanntmachung des Hinweises auf die Patenterteilung: **13.05.2020**
(21) Anmeldenummer: 05784377.3
(22) Anmeldetag: 20.09.2005
(51) Int. Cl.: C08J 7/00, C08G 73/00, C08G 61/00, C08G 61/12, H01L 51/00, H01L 51/30

(54) **ELEKTRONISCHE VORRICHTUNGEN ENTHALTEND ORGANISCHE HALBLEITER**
ELECTRONIC DEVICES CONTAINING ORGANIC SEMI-CONDUCTORS
DISPOSITIFS ELECTRIQUES CONTENANT DES SEMICONDUCTEURS ORGANIQUES

(30) Priorität: 01.10.2004 EP 04023475
(43) Veröffentlichungstag der Anmeldung: 13.06.2007
(73) Patentinhaber: Merck Patent GmbH, 64293 Darmstadt (DE)
(72) Erfinder: SPREITZER, Hubert, 68519 Viernheim (DE); LUDEMANN, Aurelie, 60322 Frankfurt (DE); SCHEURICH, René, 64846 Gross-Zimmern (DE); SCHULTE, Niels, 65779 Kelkheim (DE); BÜSING, Arne, 65929 Frankfurt (DE); STÖSSEL, Philipp, 60487 Frankfurt am Main (DE)
(86) Internationale Anmeldenummer: PCT/EP2005/010112
(87) Internationale Veröffentlichungsnummer: WO 2006/037458

(56) Entgegenhaltungen:
- WO-A-2004/106403
- WO-A1-2004/055129
- WO-A2-2004/055921
- WO-A2-2004/072205
- US-A- 5 965 679
- US-B1- 6 235 660
- KIEBOOMS R ET AL: "SYNTHESIS, ELECTRICAL, AND OPTICAL PROPERTIES OF CONJUGATED POLYMERS" HANDBOOK OF ADVANCED ELECTRONIC AND PHOTONIC MATERIALS AND DEVICES, Bd. 8, 2001, Seiten 1-102, XP001029240
- Addy Van Dijken ET AL: "Carbazole Compounds as Host Materials for Triplet Emitters in Organic Light-Emitting Diodes:? Polymer Hosts for High-Efficiency Light-Emitting Diodes", Journal of the American Chemical Society, vol. 126, no. 24, 1 June 2004 (2004-06-01) , pages 7718-7727, XP055067498, ISSN: 0002-7863, DOI: 10.1021/ja049771j
- Klemens Brunner ET AL: "Carbazole Compounds as Host Materials for Triplet Emitters in Organic Light-Emitting Diodes:? Tuning the HOMO Level without Influencing the Triplet Energy in Small Molecules", Journal of the American Chemical Society, vol. 126, no. 19, 23 April 2004 (2004-04-23), pages 6035-6042, XP055011159, ISSN: 0002-7863, DOI: 10.1021/ja049883a
- Dongge Ma ET AL: "Bright electroluminescence from a new conjugated dendrimer", SYNTHETIC METALS, vol. 137, no. 1-3, 1 April 2003 (2003-04-01), pages 1125-1126, XP055495031, CH ISSN: 0379-6779, DOI: 10.1016/S0379-6779(02)00954-2

## Beschreibung

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. So finden bereits seit etlichen Jahren organische Ladungstransportmaterialien (i. d. R. Lochtransporter auf Triarylaminbasis) Verwendung in Kopiergeräten. Die Entwicklung organischer Transistoren (O-TFTs, O-FETs), organischer integrierter Schaltungen (O-ICs) und organischer Solarzellen (O-SCs) ist im Forschungsstadium schon sehr weit gediehen, so dass eine Markteinführung innerhalb der nächsten Jahre erwartet werden kann. Bei den organischen Elektrolumineszenzvorrichtungen (OLEDs) ist die Markteinführung bereits erfolgt, wie beispielsweise die Autoradios der Firma Pioneer oder eine Digitalkamera der Firma Kodak mit "organischem Display" belegen. Auch bei den polymeren lichtemittierenden Dioden (PLEDs) sind erste Produkte in Form einer kleinen Anzeige in einem Rasierapparat und einem Mobiltelefon der Firma Philips N. V. am Markt erhältlich. Der allgemeine Aufbau solcher PLEDs ist in WO 90/13148 wiedergegeben. Trotz aller Fortschritte sind noch deutliche Verbesserungen nötig, um diese Displays zu einer echten Konkurrenz zu den derzeit marktbeherrschenden Flüssigkristallanzeigen (LCD) zu machen bzw. diese zu überflügeln.

Insbesondere die Lebensdauer, aber auch die Effizienz dieser Vorrichtungen ist bislang noch ungenügend, so dass zwar einfachere Vorrichtungen, wie oben beschrieben, bereits als kommerzielle Produkte erhältlich sind, hochwertige langlebige Vorrichtungen, wie beispielsweise für Laptops, Fernseher, etc., bislang jedoch noch nicht realisiert werden können. Zur Verbesserung dieser Eigenschaften wurden in den letzten Jahren Optimierungen, sowohl der chemischen Strukturen der verwendeten Materialien wie auch des Deviceaufbaus, vorgenommen. Dadurch konnten bereits deutliche Fortschritte erzielt werden. Jedoch sind noch weitere Verbesserungen nötig, um diese Materialien in hochwertigen Vorrichtungen einsetzen zu können.

Die Bedeutung der Materialreinheit für organische elektronische Vorrichtungen wurde bereits in der Literatur erwähnt:

So werden in US 5,965,679 organische Oligomere mit einem Halogengehalt von weniger als 20 ppm offenbart. Diese Oligomere werden als isolierende Schicht zwischen leitende Stromkreise und Schichten eingebracht.

In US 6,235,660 B1 werden antistatische Reinraumprodukte offenbart, welche an der Oberfläche eine Beschichtung aus elektrisch leitenden Teilchen aufweisen. Als elektrisch leitendes Polymer wird beispielsweise Polypyrrol offenbart, welches einen Chlorgehalt von weniger als 1 ppm aufweist.

In R. Kiebooms et al.: "Synthesis, electrical and optical properties of conjugated polymers", Handbook of advanced Electronic and Photonic Materials and Devices, Bd. 8, 2001, Seiten 1-102, wird die Synthese von halbleitenden Polymeren und deren Verwendung in organischen elektronischen Vorrichtungen offenbart. Dabei werden unter anderem Synthesen beschrieben, an denen ein reaktives Halogen beteiligt ist. Jedoch kann diesem Dokument keine Offenbarung über den Halogengehalt der beschriebenen organischen Halbleiter entnommen werden.

WO 2004/106403 A1 offenbart eine elektronische Vorrichtung enthaltend ein hochreines, ionenfreies Polythiophen, wobei der Gehalt an Brom weniger als 40 ppm beträgt, sowie ein Verfahren zur Herstellung eines solchen Polythiophens durch Behandlung des Polythiophen-Rohprodukts mit einer metallorganischen Verbindung in einem inerten Lösungsmittel.

In Addy van Diyken et al: "Carbazole compounds as host materials for triplet emitters in organic light-emitting diodes: Polymer hosts for high-efficiency light-emitting diodes", Journal of American Chemical Society, Bd. 126, Nr. 24, 1. Juni 2004, Seiten 7718-7727, wird die Herstellung eines Polymeren mit einem Bromgehalt von weniger als 15 ppm sowie dessen Verwendung in einer OLED beschrieben.

K. Brunner et al. beschreiben im Journal of Americal Chemical Society, Bd. 126, Nr. 19, 23. April 2004, Seiten 6035-6042, die Herstellung von Carbazol Verbindungen als Host-Materialien für Triplett Emitter in organischen Licht-emittierenden Dioden.

In WO 2004/055129 A1 werden elektrolumineszierende Vorrichtungen offenbart, die ein ladungstransportierendes, konjugiertes Donor-Polymer und eine phosphoreszierende Akzeptor-Verbindung enthalten.

In WO 2004/072205 A2 werden niedermolekulare oder polymere Carbazolverbindungen offenbart, die zwei oder mehr miteinander verknüpfte Carbazoleinheiten aufweisen.

In WO 2004/055921 A2 werden organische elektrolumineszierende Vorrichtungen offenbart, die in der emittierenden Schicht ein p- oder n-dotiertes organisches Matrixmaterial und in dieser Matrix einen phosphoreszierenden metallorganischen Komplex enthalten.

Donge et al. beschreiben in Synthetic Metals, Bd. 137, Nr. 1-3, 1. April 2003, Seiten 1125-1126, organische Licht-emittierende Dioden, die konjugierte Dendrimere enthalten, die aus Distyrylbenzoleinheiten aufgebaut sind, welche über ein zentrales Stickstoffatom miteinander verknüpft sind.
So werden in EP 0895442 OLEDs beschrieben, in denen nicht mehr als 10¹³ Elektronenspins pro mg Verbindung existieren, da diese als Traps für Elektronen und Löcher wirken. Diese Elektronenspins stammen vermutlich unter anderem von Verunreinigungen der Verbindungen und können beispielsweise durch Sublimation wirkungsvoll abgetrennt werden.

In EP 1087448 wird beschrieben, dass die Anwesenheit ionischer Verunreinigungen aus der ersten und zweiten Gruppe des Periodensystems der Elemente, insbesondere Na und K, zu hohem Stromfluss ohne Rekombination und Lichtemission in der Vorrichtung führt, wodurch unnötig Wärme erzeugt wird, die der Vorrichtung schadet. Deshalb werden dort organische Halbleiter vorgeschlagen, deren Gehalt an den oben genannten ionischen Verunreinigungen kleiner als 0.1 ppm ist. Zur Reinigung der Materialien werden die für organische Verbindungen üblichen Methoden, wie Umkristallisation, Sublimation, Dialyse, etc., aufgeführt.

In JP 2004/039566 wird beschrieben, wie durch Einsatz von Chelatbildnern metallische Verunreinigungen, die beispielsweise in der Synthese als Katalysatoren eingesetzt wurden, aus organischen Halbleitern entfernt werden können. Der Einsatz von Komplexbildnern zu diesem Zweck ist beispielsweise auch in WO 03/048225 und in WO 00/53656 beschrieben.

In JP 2004/039567 wird beschrieben, wie durch Einsatz von Chelatbildnern Bor-Verunreinigungen, die als Nebenprodukte der Synthese anwesend sein können, aus organischen Halbleitern entfernt werden können. Diese Methode hat jedoch den Nachteil, dass damit zwar freie Bor-Verunreinigungen, nicht aber an den Halbleiter gebundene Verunreinigungen (bzw. nicht abreagierte Edukte), die nicht mit dem Chelatbildner reagieren, entfernt werden können. Dadurch kann der Bor-Gehalt nicht auf einen sehr niedrigen Gehalt gesenkt werden.

In JP 2003/347624 wird beschrieben, wie durch Einsatz superkritischer Lösemittel der Gehalt an Verunreinigungen in organischen Halbleitern bis zu zwischen 0.01 und 50 ppm gesenkt werden kann. Ebenso wie oben hat auch diese Methode den Nachteil, dass sie nur freie Verunreinigungen erfassen kann, nicht aber Verunreinigungen, die kovalent an die Reaktionsnebenprodukte (oder nicht abreagierte Edukte) des organischen Halbleiters gebunden sind, wie beispielsweise nicht reagierte funktionelle Gruppen, z. B. Halogen-Substituenten oder Boronsäurederivate.

EP 1063869 beschreibt OLEDs, in denen die organischen Komponenten weniger als 500 ppm Verunreinigungen, insbesondere halogen-haltige Verunreinigungen, enthalten. Eigene Experimente belegen jedoch, dass ein solcher Gehalt an Verunreinigungen noch mehr als eine Größenordnung zu hoch ist, um den gewünschten Effekt zu erzielen. So lassen sich durch einen Gehalt an halogenhaltigen Verunreinigungen im Bereich von nahe 500 ppm vielleicht bereits erste kleine Effekte erzielen, aber die Aufgabe, reproduzierbar langlebige organische elektronische Vorrichtungen zu erzeugen, wird dadurch nicht gelöst.

Aus diesen Beschreibungen wird deutlich, dass durch die genannten Reinheitsanforderungen und Aufreinigungen zwar die Eigenschaften der Materialien verbessert werden konnten; die oben beschriebenen Probleme sind damit jedoch noch nicht zufriedenstellend gelöst. Insbesondere wurde gefunden, dass bestimmte, unten näher spezifizierte, Verunreinigungen auch in sehr geringen Anteilen die Funktion der elektronischen Vorrichtung, insbesondere die Lebensdauer, deutlich stören können. Ohne an eine bestimmte Theorie gebunden sein zu wollen, vermuten wir, dass dies nicht nur frei vorliegende Verunreinigungen sind, sondern vor allem auch an den organischen Halbleiter bzw. Halbleiternebenprodukte gebundene Verunreinigungen oder auch nicht abreagierte Edukte, insbesondere Halogene, die von der Reaktion verbleiben können. Diese kovalent gebundenen Verunreinigungen können durch die oben genannten Methoden nicht abgetrennt werden. Andererseits sind reaktive Halogene sehr häufig an der Synthese organischer Halbleiter bzw. deren Vorstufen beteiligt und liegen daher auch üblicherweise als Verunreinigung in unterschiedlichen Anteilen im organischen Halbleiter vor. Es ist daher die Aufgabe der vorliegenden Erfindung, hierfür eine technische Verbesserung anzubieten. Gegenstand der Erfindung sind elektronische Vorrichtungen enthaltend mindestens einen organischen Halbleiter, der durch eine Reaktion erhalten wurde, an der mindestens ein reaktives Halogen beteiligt war, dadurch gekennzeichnet, dass der Gehalt an dem Halogen, welches an der Reaktion beteiligt war, im organischen Halbleiter kleiner als 20 ppm ist, und dass der Gehalt an den Halogenen Fluor, Chlor, Brom und Iod im organischen Halbleiter jeweils kleiner als 20 ppm ist, mit der Maßgabe, dass diese Begrenzung für Fluor nur dann gilt, wenn Fluor nicht konstituierender Bestandteil der chemischen Struktur des organischen Halbleiters ist; mit der Maßgabe, dass der organische Halbleiter kein Polythiophen ist, das durch eine Reaktion erhalten wurde, an der Brom als reaktives Halogen beteiligt war, und das einen Gehalt an Brom von weniger als 20 ppm aufweist.

Organische Halbleiter sind üblicherweise insbesondere solche, bei deren Herstellung ein reaktives Brom oder auch ein reaktives Iod oder Chlor insbesondere an einer der folgenden Reaktionen beteiligt ist: Kupplung gemäß Suzuki, Kupplung gemäß Stille, Kupplung gemäß Yamamoto, Kupplung gemäß Heck, Kupplung gemäß Hartwig-Buchwald, Kupplung gemäß Sonogashira, Kupplung gemäß Negishi oder Kupplung gemäß Hiyama. Organische Halbleiter sind weiterhin üblicherweise insbesondere solche, bei deren Synthese ein reaktives Chlor an einer Gilch-Reaktion beteiligt ist. Dieses reaktive Halogen wird während der Reaktion abgespalten.

Die elektronische Vorrichtungen, enthaltend mindestens einen organischen Halbleiter, sind bevorzugt ausgewählt aus der Gruppe elektronischer Vorrichtungen, bestehend aus organischen und polymeren Leuchtdioden (OLEDs, PLEDs), aber auch organischen Feld-Effekt-Transistoren (O-FETs), organischen Dünnfilmtransistoren (O-TFTs), organischen integrierten Schaltungen (O-ICs), organischen Solarzellen (O-SCs), organische Feld-Quench-Devices (O-FQDs), organische lichtemittierende Transistoren (O-LETs), lichtemittierende elektrochemische Zellen (LECs) oder auch organischen Laserdioden (O-Laser), um nur einige Anwendungen zu nennen.
Bevorzugt sind elektronische Vorrichtungen, dadurch gekennzeichnet, dass der Gehalt an Brom im organischen Halbleiter kleiner als 20 ppm ist.

Bevorzugt sind weiterhin elektronische Vorrichtungen, dadurch gekennzeichnet, dass alle organischen Halbleiter in allen Schichten weniger als 20 ppm Brom enthalten.

Organische Halbleiter im Sinne dieser Anmeldung sind niedermolekulare, oligomere, dendritische oder polymere, organische oder metallorganische Verbindungen, die als Feststoff bzw. als Schicht halbleitende Eigenschaften aufweisen, d. h. bei denen die Energielücke zwischen Leitungs- und Valenzband zwischen 1.0 und 3.5 eV liegt. Als organischer Halbleiter wird hier entweder eine Reinkomponente oder eine Mischung von zwei oder mehreren Komponenten, von denen mindestens eine halbleitende Eigenschaften aufweisen muss, verwendet. Bei der Verwendung von Mischungen ist es jedoch nicht notwendig, dass jede der Komponenten halbleitende Eigenschaften aufweist. So können beispielsweise auch elektronisch inerte Verbindungen, wie z. B. Polystyrol, zusammen mit halbleitenden Verbindungen verwendet werden.

In einer bevorzugten Ausführungsform der Erfindung ist der organische Halbleiter in der elektronischen Vorrichtung polymer. Als polymere organische Halbleiter im Sinne der vorliegenden Beschreibung werden insbesondere
(i) die in EP 0443861, WO 94/20589, WO 98/27136, EP 1025183, WO 99/24526, WO 01/34722 und EP 0964045 offenbarten, substituierten Poly-p-arylen-vinylene (PAVs),
(ii) die in EP 0842208, WO 00/22027, WO 00/22026, DE 19981010, WO 00/46321, WO 99/54385 und WO 00/55927 offenbarten, substituierten Polyfluorene (PFs),
(iii) die in EP 0707020, WO 96/17036, WO 97/20877, WO 97/31048, WO 97/39045 und WO 03/020790 offenbarten, substituierten Poly-spirobifluorene (PSFs),
(iv) die in WO 92/18552, WO 95/07955, EP 0690086, EP 0699699 und WO 03/099901 offenbarten, substituierten Poly-para-phenylene (PPPs) oder -biphenylene,
(v) die in WO 05/014689 offenbarten, substituierten Poly-dihydrophenanthrene (PDHPs),
(vi) die in WO 04/041901 und WO 04/113412 offenbarten, substituierten Poly-trans-indenofluorene und Poly-cis-indenofluorene (PIF),
(vii) die in EP 1028136 und WO 95/05937 offenbarten, substituierten Polythiophene (PTs),
(viii) die in T. Yamamoto et al., J. Am. Chem. Soc. 1994, 116, 4832 offenbarten Polypyridine (PPys),
(ix) die in V. Gelling et al., Polym. Prepr. 2000, 41, 1770 offenbarten Polypyrrole,
(x) die in DE 102004020298.2 offenbarten, substituierten Poly-phenanthrene,
(xi) phosphoreszierende Polymere, wie beispielsweise beschrieben in DE 102004032527.8,
(xii) die in WO 02/10129 beschriebenen vernetzbaren Polymere,
(xiii) substituierte, lösliche Copolymere, die Struktureinheiten aus zwei oder mehr der Klassen (i) bis (xii) aufweisen, wie zum Beispiel in WO 02/077060 beschrieben,
(xiv) die in Proc. of ICSM '98, Part I & II (in: Synth. Met. 1999, 101/102) offenbarten konjugierten Polymere,
(xv) substituierte und unsubstituierte Poly-vinyl-carbazole (PVKs), wie beispielsweise in R. C. Penwell et al., J. Polym. Sci., Macromol. Rev. 1978, 13, 63-160 offenbart, und
(xvi) substituierte und unsubstuierte Triarylaminpolymere, wie beispielsweise in JP 2000-072722 offenbart,
verstanden.

In einer weiteren bevorzugten Ausführungsform der Erfindung werden niedermolekulare, organische oder metallorganische Halbleiter verwendet, wobei als niedermolekulare Verbindung eine Verbindung mit einem Molekulargewicht von kleiner 10000 g/mol, bevorzugt kleiner 5000 g/mol verstanden werden soll.

In einer weiteren bevorzugten Ausführungsform der Erfindung werden dendritische organische oder metallorganische Halbleiter verwendet. Beispiele für dendritische organische oder metallorganische Halbleiter können in WO 99/21935,
WO 01/059030 und WO 02/066552 gefunden werden.
Bevorzugt ist der Gehalt an mindestens einem Halogen, bzw. der Gehalt an Brom, bzw. jeweils der Gehalt an Fluor, sofern Fluor kein konstituierender Bestandteil der chemischen Struktur ist, Chlor, Brom und Iod, im organischen Halbleiter kleiner als 10 ppm, besonders bevorzugt kleiner als 5 ppm, ganz besonders bevorzugt kleiner als 1 ppm, insbesondere kleiner als 0.1 ppm. Dies gilt insbesondere dann, wenn dieses entsprechende Halogen an einem vorhergehenden Reaktionsschritt bei der Herstellung des organischen Halbleiters beteiligt war. Es hat sich gezeigt, dass sich mit einem solch niedrigen Gehalt an Halogenen besonders gute Ergebnisse in den elektronischen Vorrichtungen erzielen lassen. Dies bezieht sich insbesondere auf die schwereren Halogene Chlor, Brom und Iod.
Halogene, insbesondere Brom und Iod oder auch Chlor, liegen häufig in organischen Halbleitern als Verunreinigung vor, wenn für die Synthese metallkatalysierte Kupplungsreaktionen (z. B. Suzuki-Kupplung, Yamamoto-Kupplung, Hartwig-Buchwald-Kupplung, etc.) angewendet wurden, wie sie zur Synthese organischer Halbleiter weit verbreitet sind. Da diese Kupplungsreaktionen auch zur Synthese konjugierter Polymere verwendet werden, weisen auch polymere organische Halbleiter diese Verunreinigungen auf. Chlor als Verunreinigung liegt vor allem nach der Synthese von Poly-para-phenylenvinylenen nach der Gilch-Methode vor, da diese Methode von Halogenmethyl-, bevorzugt Chlormethyl-substituierten Aromaten ausgeht. Diese Verunreinigungen können sowohl frei, z. B. als Anion oder als niedermolekular gebundenes Halogen mit C-X-Bindung, vorliegen als auch kovalent an den organischen Halbleiter bzw. dessen Nebenprodukte oder Edukte gebunden. Insbesondere kovalent gebundene Halogene sind nicht durch einfache Aufreinigungverfahren, wie beispielsweise Umkristallisation, Sublimation, Umfällen, etc., zu entfernen. Sie lassen sich also nach Standardmethoden gemäß dem Stand der Technik kaum soweit abtrennen, dass der Gehalt an diesen Verunreinigungen ausreichend niedrig ist, um gute elektronische Eigenschaften zu gewährleisten.

Weiterhin hat sich gezeigt, dass die elektronischen Eigenschaften, insbesondere die Lebensdauer, aber auch Effizienz, der organischen elektronischen Vorrichtung noch weiter gesteigert werden können, wenn zusätzlich zum geringen Gehalt an Halogenen der Gehalt anderer Elemente, die als Verunreinigungen bzw. in Nebenprodukten vorliegen können, im organischen Halbleiter einen bestimmten Anteil unterschreitet.

So ist es bevorzugt, wenn der Gehalt an Schwefel im organischen Halbleiter kleiner als 20 ppm ist, besonders bevorzugt kleiner als 10 ppm, ganz besonders bevorzugt kleiner als 5 ppm, insbesondere kleiner als 1 ppm, sofern Schwefel nicht als konstituierender Bestandteil der chemischen Struktur in den organischen Halbleiter gebunden ist, z. B. in Thiophenen. Schwefel-Verunreinigungen können beispielsweise aus der Aufarbeitung der organischen Halbleiter stammen, wenn beispielsweise nach einer metallkatalysierten Kupplungsreaktion das Metall durch Extraktion mit Thiocarbamat-Lösung abgetrennt wird. Schwefel-Verunreinigungen können auch aus der Synthese stammen, wenn beispielsweise Sulfonate in einer Suzuki-Kupplung eingesetzt wurden.

Weiterhin ist es bevorzugt, wenn der Gehalt an Phosphor im organischen Halbleiter kleiner als 20 ppm ist, besonders bevorzugt kleiner als 10 ppm, ganz besonders bevorzugt kleiner als 5 ppm, insbesondere kleiner als 1 ppm, sofern Phosphor nicht als konstituierender Bestandteil der chemischen Struktur in den organischen Halbleiter gebunden ist, z. B. in Triarylphosphinen. Phosphor-Verunreinigungen können beispielsweise aus dem Katalysator, der für metallkatalysierte Kupplungsreaktionen eingesetzt wird, beispielsweise aus aliphatischen oder aromatischen Phosphinliganden, stammen, aber auch aus Phosphat-haltigen Basen oder Puffersystemen.

Weiterhin ist es bevorzugt, wenn der Gehalt an Silicium im organischen Halbleiter kleiner als 20 ppm ist, besonders bevorzugt kleiner als 10 ppm, ganz besonders bevorzugt kleiner als 5 ppm, insbesondere kleiner als 1 ppm, sofern Silicium nicht als konstituierender Bestandteil der chemischen Struktur in den organischen Halbleiter gebunden ist. Silicium-Verunreinigungen können beispielsweise aus Glasreaktionsgefäßen oder Kesselemaillierungen, in denen die Reaktionen durchgeführt wurden, stammen und, insbesondere durch Zusatz von Fluorid und/oder basische Reaktionsbedingungen, wie sie für manche Kupplungsreaktionen benötigt werden, aus dem Glas bzw. Email herausgelöst werden (Fluorosilicate). Silicium-Verunreinigungen können auch aus der Synthese stammen, wenn beispielsweise Arylsilane in einer Hiyama-Kupplung eingesetzt werden.

Weiterhin ist es bevorzugt, wenn der Gehalt an Bor im organischen Halbleiter kleiner als 20 ppm ist, besonders bevorzugt kleiner als 10 ppm, ganz besonders bevorzugt kleiner als 5 ppm, insbesondere kleiner als 1 ppm, sofern Bor nicht als konstituierender Bestandteil der chemischen Struktur in den organischen Halbleiter gebunden ist, beispielsweise in Triarylboranen. Bor-Verunreinigungen können aus dem Glasreaktionsgefäß stammen (Borate), in dem die Reaktion durchgeführt wurde. Sie können aber auch aus der Reaktion selber stammen, wenn z. B. bei Suzuki-Kupplungsreaktionen Boronsäure-Derivate eingesetzt werden. Diese können dann entweder frei als Reaktionsnebenprodukte oder als nicht abreagierte Edukte an den organischen Halbleiter gebunden vorliegen.
Weiterhin ist es bevorzugt, wenn der Gehalt an Zinn und/oder an Zink im organischen Halbleiter kleiner als 20 ppm ist, besonders bevorzugt kleiner als 10 ppm, ganz besonders bevorzugt kleiner als 5 ppm, insbesondere kleiner als 1 ppm. Zinn- oder Zink-Verunreinigungen können aus der Reaktion stammen, wenn z. B. bei Stille- bzw. Negishi-Kupplungsreaktionen Zinn- bzw. Zink-Derivate eingesetzt werden. Diese können dann entweder frei als Reaktionsnebenprodukte oder als nicht abreagierte Edukte an den organischen Halbleiter gebunden vorliegen.

Der Gehalt an den oben genannten Verunreinigungen kann durch verschiedene analytische Standardmethoden bestimmt werden. Als Beispiele seien hier ICP-MS (inductively coupled plasma mass spectrometry), LA-ICP-MS (laser ablation inductively coupled plasma mass spectrometry), GDMS (glow discharge mass spectrometry), SIMS (secondary ion mass spectrometry), ICP-OES (inductively coupled plasma optical emission spectroscopy) und bevorzugt Neutronenaktivierung genannt. Einen Überblick über die verschiedenen massenspektrometrischen Methoden geben beispielsweise J. S. Becker et al., Internat. J. Mass Spectrometry 2003, 228, 127-150. Einen Überblick über die Analytik durch Neutronenaktivierung geben beispielsweise R. Zeisler et al., Handbook of Nuclear Chemistry, Ed. A. Vertes, 2003, 3, 303-362, Kluwer Academic Publishers, und S. Landsberger, ACS Symposium 2004, 868 (Radioanalytical Methods in Interdisciplinary Research), 307-336. Mit diesen Methoden lässt sich der Gehalt an den genannten Verunreingungen sehr genau und bis zu einem Gehalt von 0.1 ppm und weniger bestimmen, für viele Elemente sogar bis in den ppb-Bereich. Daher sind diese Methoden besonders geeignet zur Bestimmung des Gehalts an Verunreinigungen. Die Standard-Analytikmethoden zur Charakterisierung chemischer Verbindungen in der organischen Synthese, wie beispielsweise NMR oder HPLC, sind zur Bestimmung derart geringer Anteile an Verunreinigungen ungeeignet.
Gegenstand der Erfindung ist weiterhin die Verwendung eines organischen Halbleiters, der durch eine Reaktion erhalten wurde, an der mindestens ein reaktives Halogen beteiligt war, mit einem Gehalt an dem Halogen, welches an der Reaktion beteiligt war, kleiner als 20 ppm in einer elektronischen Vorrichtung, und dass der Gehalt an den Halogenen Fluor, Chlor, Brom und Iod im organischen Halbleiter jeweils kleiner als 20 ppm ist, mit der Maßgabe, dass diese Begrenzung für Fluor nur dann gilt, wenn Fluor nicht konstituierender Bestandteil der chemischen Struktur des organischen Halbleiters ist;
mit der Maßgabe, dass der organische Halbleiter kein Polythiophen ist, das durch eine Reaktion erhalten wurde, an der Brom als reaktives Halogen beteiligt war, und das einen Gehalt an Brom von weniger als 20 ppm aufweist.

Ein weiterer Aspekt der vorliegenden Erfindung sind organische Halbleiter, erhältlich durch ein Verfahren umfassend die folgenden Schritte:
a) Herstellung des organischen Halbleiters mittels einer Reaktion mit einem reaktiven Halogen, insbesondere Kupplung gemäß Suzuki, Kupplung gemäß Stille, Kupplung gemäß Yamamoto, Kupplung gemäß Heck, Kupplung gemäß Hartwig-Buchwald, Kupplung gemäß Sonogashira, Kupplung gemäß Negishi, Kupplung gemäß Hiyama oder Gilch-Reaktion;
b) gegebenenfalls Isolierung des organischen Halbleiters aus a);
c) Nachbehandlung des organischen Halbleiters derart, dass der Gehalt an den Halogenen im organischen Halbleiter reduziert wird;
mit der Maßgabe, dass die Nachbehandlung nicht mittels Behandeln mit einer metallorganischen Verbindung in einem inerten Lösemittel und anschließendem Isolieren durchgeführt wird, wenn es sich bei dem Verfahrensprodukt um ein Polythiophen mit einem Bromgehalt von weniger als 20 ppm handelt.

Üblicherweise ist nach Schritt a) der Halogengehalt, insbesondere der Bromgehalt, wenn reaktives Brom an der Reaktion beteiligt war, deutlich höher als 20 ppm. Die Nachbehandlung des organischen Halbleiters kann direkt im Anschluss an die letzte Synthesestufe in situ erfolgen. Bevorzugt ist es jedoch, den organischen Halbleiter als Feststoff zu isolieren und die Nachbehandlung in einem separaten Reaktionsschritt durchzuführen.

Geeignete Reagenzien zur Nachbehandlung sind solche, die mit organisch gebundenen Halogenen, insbesondere mit an Aromaten gebundenen Halogenen, reagieren.
Bevorzugt sind Reduktionsmittel, die das Halogen reduzieren und gegen Wasserstoff austauschen.
Hierfür eignen sich besonders einfache Hydride der Alkali- oder Erdalkalimetalle, beispielsweise NaH, MgH₂ oder LiH, ternäre Hydride enthaltend Bor oder Aluminium, wie beispielsweise LiAlH₄, NaAlH₄, LiBH₄, NaBH₄, NaB(CN)₃H, LiAlR₃H, LiAl(OR)₃H, NaBR₃H oder NaB(OR)₃H, wobei R für eine C₁ bis C₆ Alkylgruppe steht, Alane, wie beispielsweise AlH₃ oder R₂AlH, wobei R für eine C₁ bis C₆ Alkylgruppe steht, oder Borane, wie beispielsweise B₂H₆, BH₃·THF oder R₂BH, wobei R für eine C₁ bis C₆ Alkylgruppe steht. Weiterhin eignen sich Übergangmetallhydride, die eher den Charakter von Legierungen von Metallen mit Wasserstoff besitzen, insbesondere Titanhydrid, Hydride der Titanlegierungen mit Cr, Mn oder Ni, sowie wasserstoffhaltige Legierungen, enthaltend Magnesium und/oder Aluminium, welche noch weitere Metalle zur Aktivierung enthalten können. Weiterhin eignen sich hierfür komplexe Übergangsmetallhydride, beispielsweise Cyclopentadienylmetallhydride, z. B. (Cp)₂TiH₂ oder (Cp)₂MoH₂, oder Carbonylmetallhydride, z. B. Mn(CO)₅H oder Fe(CO)₄H₂. Weiterhin bevorzugt sind Hauptgruppen-Element-Hydride, beispielsweise Silane, Alkylsilane oder Halogensilane, z. B. SiH₄, Me₃SiH, H₃SiBr, etc., oder Stannane, Alkylstannane oder Halogenstannane, beispielsweise SnH₄, Bu₃SnH, Cl₃SnH, etc. Alle diese Hydride können fakultativ auch in Kombination mit einer Lewis-Säure, wie beispielsweise AlCl₃ oder ZnCl₂, zur Unterstützung der Reaktion eingesetzt werden.
Weiterhin bevorzugt sind homogene oder heterogene Übergangsmetallkatalysatoren, inbesondere enthaltend Elemente der Platin-Gruppe, vor allem Rhodium, Iridium, Palladium oder Platin, die zusammen mit elementarem Wasserstoff, gegebenenfalls unter Druck, oder einer Hydridquelle reagieren. Hier sei als Beispiel Vaskas Komplex ((PPh₃)₂Ir(CO)Cl) in Kombination mit H₂ genannt.
Als weitere Hydridquelle können organische Verbindungen dienen, beispielsweise Hydrochinone, gegebenenfalls in Kombination mit einem Katalysator.
Weiterhin bevorzugt sind metallorganische Reagenzien, die Transmetallierung eingehen und so das Halogen gegen ein Metallatom austauschen, beispielsweise Alkyl- oder Aryllithium-Reagenzien, Alkyl- oder Aryl-Grignard-Reagenzien oder Alkyl- oder Arylzink-Reagenzien.
Ebenfalls bevorzugt sind reaktive Metalle, die das Halogen gegen ein Metallatom austauschen, beispielsweise Alkali- oder Erdalkalimetalle, bevorzugt Mg, Li oder Na, aber auch Legierungen von Alkalimetallen miteinander oder mit anderen Metallen, wie In oder Ga, oder auch reaktive Übergangsmetalle, wie beispielsweise Zn.

Bevorzugt werden diese Metalle in fein verteilter Form eingesetzt. Die metallhaltigen Derivate der organischen Halbleiter, die durch Transmetallierung oder Umsetzung mit reaktiven Metallen erhalten werden, können in einem weiteren Schritt in die endgültige Verbindung umgesetzt werden. Hier kommt insbesondere die Hydrolyse mit einer protischen Verbindung, beispielsweise mit Wasser oder einem Alkohol, in Frage, was in der unsubstituierten Verbindung resultiert. Weiterhin kommt beispielsweise eine metallkatalysierte Kupplungsreaktion mit einer Arylbromid oder -iodid in Frage, wobei eine arylsubstituierte Verbindung entsteht (z. B. Kupplung gemäß Negishi).
Nochmals eine weitere bevorzugte Methode zur Nachbehandlung halogenhaltiger organischer Halbleiter ist die Kupplung mit Aminen, Aryl-, Vinyl- oder Acetylen-Verbindungen, etc. unter Übergangsmetallkatalyse. Hier kommen beispielsweise die Umsetzung mit einer Vinyl-H-Verbindung (Kupplung gemäß Heck), mit einem Aryl-Boronsäurederivat (Kupplung gemäß Suzuki), mit einem Aryl-Zinnderivat (Kupplung gemäß Stille), mit einem aromatischen Amin (Kupplung gemäß Hartwig-Buchwald), mit einer Acetylen-H-Verbindung (Kupplung gemäß Sonogashira) oder mit einem Arylsilan-Derivat (Kupplung gemäß Hiyama), jeweils katalysiert durch Palladium, in Frage. Ebenso kommt die Kupplung mit Arylhalogeniden, besonders Bromiden oder Iodiden, unter Einsatz von Nickelverbindungen in Frage (Kupplung gemäß Yamamoto).
Es ist auch möglich, die halogenierten organischen Halbleiter durch entsprechende geeignete Mikroorganismen zu dehalogenieren, bzw. die entsprechenden halogenierten Verbindungen selektiv durch entsprechende Mikroorganismen zerstören zu lassen, während der nicht-halogenierte organische Halbleiter intakt bleibt.

Analog ist zur Verringerung des Bor-Gehalts, beispielsweise nach einer Synthese, an der eine Kupplung gemäß Suzuki beteiligt war, als Folgeschritt die Umsetzung mit einem niedermolekularen Arylbromid unter Palladiumkatalyse möglich. Dadurch werden im organischen Halbleiter verbliebene Boronsäuregruppen mit dem Arylbromid gekuppelt und so aus dem Halbleiter entfernt. Da hier bevorzugt ein niedermolekulares Arylbromid eingesetzt wird, kann dieses nach der Nachbehandlung durch einfache Aufreinigungsverfahren, beispielsweise durch Umkristallisation, Umfällen oder einfach Waschen, aus dem organischen Halbleiter entfernt werden und verbleibt nicht als Halogenverunreinigung im Produkt.

Die Nachbehandlung kann in organischen Lösemitteln durchgeführt werden. Sie kann aber auch in verflüssigten oder superkritischen Gasen, beispielsweise in flüssigem NH₃ oder SO₂ oder in superkritischem CO₂ durchgeführt werden. Diese Lösemittel bieten den Vorteil, dass nach Abdampfen des Lösemittels das vorgereinigte Produkt einfach isoliert werden kann.

Eine bevorzugte Nachbehandlungsreaktion ist eine Kupplungsreaktion unter Übergangsmetall-, insbesondere Palladiumkatalyse. Insbesondere bevorzugt ist eine Kupplung gemäß Suzuki, wobei als Reagenz ein niedermolekulares Boronsäurederivat eingesetzt wird. Dies gilt insbesondere für polymere organische Halbleiter, da bei diesen ein eventueller Überschuss an niedermolekularem Boronsäurederivat nach der Reaktion einfach, beispielsweise durch Waschen oder Umfällen, abgetrennt werden kann.
Eine weitere bevorzugte Nachbehandlungsreaktion ist die Umsetzung mit Metallorganylen oder reaktiven Metallen unter Bildung eines metallorganischen Zwischenprodukts des organischen Halbleiters und folgender Hydrolyse. Dies gilt insbesondere dann, wenn der organische Halbleiter außer den Halogenverunreinigungen keine reaktiven Gruppen trägt, die mit Metallorganylen oder reaktiven Metallen reagieren können. Bevorzugt ist die Umsetzung mit Organolithium-Verbindungen bei tiefen Temperaturen und mit Magnesium unter Bildung eines Grignard-Reagenzes bei erhöhter Temperatur, gefolgt von Hydrolyse mit Wasser oder Alkoholen.
Insbesondere metallkatalysierte Kupplungsreaktionen werden bereits gemäß dem Stand der Technik zum Endcapping bei der Synthese halbleitender Polymere eingesetzt. Jedoch werden diese Endcapper (= monofunktionelle Verbindungen) entweder bereits am Anfang der Synthese zugesetzt, oder sie werden nach Abschluss der Polymerisation in situ zur Reaktionslösung zugegeben. Da zu diesem Zeitpunkt nicht mehr immer ein stark aktives Katalysatorsystem vorliegt, kann nicht davon ausgegangen werden, dass die Polymere dann quantitativ die gewünschen Endgruppen tragen; statt dessen verbleiben hier funktionelle reaktive Gruppen im Polymer, insbesondere Halogene und Boronsäurederivate. Deshalb ist es auch durch einen Standard-Endcapping-Prozess, wie er in der Literatur beschrieben ist (beispielsweise WO 04/009668), nicht reproduzierbar möglich, den Gehalt an Halogenen im organischen Halbleiter auf einen Wert < 20 ppm zu senken. Auch bei niedermolekularen Verbindungen, insbesondere wenn der letzte Reaktionsschritt bei der Herstellung des organischen Halbleiters in einer Kupplungsreaktion besteht, an der ein Arylhalogenid beteiligt ist, verbleiben funktionelle reaktive Gruppen in der Verbindung, da organische Reaktionen üblicherweise nicht quantitativ ablaufen. Durch die Nachbehandlung in einem separaten Schritt (Schritt c)) nach Isolation der Rohpolymere bzw. der niedermolekularen Rohprodukte kann dies vermieden werden, und die Reaktion kann reproduzierbar durchgeführt werden.

Ein weiterer geeigneter Nachbehandlungsschritt zur Reduzierung des Bor-Gehalts ist die Deboronierung, z. B. mit verschiedenen Säuren (z. B. H. G. Kuivila et al., J. Am. Chem. Soc. 1960, 82, 2159-2163).

Es kann auch sinnvoll sein, mehrfach denselben oder unterschiedliche Nachbehandlungsschritte (Schritt c)) nacheinander durchzuführen, um den Gehalt an Halogenen und gegebenenfalls anderer Verunreinigungen noch weiter zu senken.

Weiterer Gegenstand der Erfindung sind Lösungen eines oder mehrerer erfindungsgemäßer organischer Halbleiter in einem oder mehreren Lösemitteln. Dabei ist es bevorzugt, wenn der Gehalt an den oben genannten Verunreinigungen in den Lösemitteln ebenfalls die oben genannten Grenzwerte unterschreitet.

Die erfindungsgemäßen elektronischen Vorrichtungen enthaltend mindestens einen organischen Halbleiter, dessen Gehalt an Halogenen allgemein und gegebenenfalls auch an weiteren Verunreinigungen, wie oben beschrieben, bestimmte Grenzwerte unterschreiten, weisen einige entscheidende Vorteile auf:
1. Die Lebensdauer und die Effizienz der elektronischen Vorrichtungen verbessern sich. Dies ist essenziell für die Entwicklung langlebiger und hochwertiger elektronischer Vorrichtungen. Diese Angaben sind in den Beispielen 3 bis 5, 8 und 9 näher ausgeführt.
2. Ein weiterer Vorteil der erfindungsgemäßen elektronischen Vorrichtungen ist das Fehlen des häufig beobachteten so genannten "initial drops". So wird ein steiler Abfall der Lumineszenz in den ersten Stunden der Lebensdauer einer OLED bzw. PLED bezeichnet, bevor der weitere Abfall durch eine näherungsweise exponentielle Kurve beschrieben werden kann. Die Ursache dieses initial drops war bislang nicht bekannt und dessen nicht reproduzierbares Auftreten, auch bei organischen Halbleitern oder Polymeren gleicher Zusammensetzung, ein Problem. Durch das Wegfallen des initial drops lassen sich also organische elektronische Vorrichtungen reproduzierbar herstellen.
3. Der Grad der Umsetzung organischer Reaktionen ist nicht immer vollständig kontrollierbar und reproduzierbar. So sind kleinere Schwankungen dabei normal. Selbst kleinste Schwankungen, beispielsweise im Bereich von 99.8 bis 99.9 % Umsatz, können jedoch, insbesondere bei Polymerisationsreaktionen, einen enormen Unterschied auf die Anzahl der vorhandenen Endgruppen im Polymer haben. Diese Endgruppen sind bei einer Polymerisation gemäß Suzuki Halogene, insbesondere Brom, und Boronsäurederivate. Durch das erfindungsgemäße Verfahren und die separate Nachbehandlung der organischen Halbleiter können diese entfernt werden, was zu einer besseren Reproduzierbarkeit des gesamten Polymerisationsprozesses (bzw. der organischen Synthese) führt.

Im vorliegenden Anmeldetext und auch in den im Weiteren folgenden Beispielen wird vor allem auf organische und polymere Leuchtdioden und die entsprechenden Displays abgezielt. Trotz dieser Beschränkung der Beschreibung ist es für den Fachmann ohne weiteres erfinderisches Zutun möglich, entsprechende organische Halbleiter auch für die Herstellung anderer Devices zu verwenden, z. B. für organische Feld-Effekt-Transistoren (O-FETs), organische Dünnfilmtransistoren (O-TFTs), organische integrierte Schaltungen (O-ICs), organische Solarzellen (O-SCs), organische Feld-Quench-Devices (O-FQDs), organische lichtemittierende Transistoren (O-LETs), lichtemittierende elektrochemische Zellen (LECs) oder auch organische Laserdioden (O-Laser), um nur einige Anwendungen zu nennen.

Die vorliegende Erfindung wird durch die folgenden Beispiele näher erläutert, ohne sie darauf einschränken zu wollen. Der Fachmann kann aus der Beschreibung und den aufgeführten Beispielen ohne erfinderisches Zutun weitere erfindungsgemäße elektronische Vorrichtungen herstellen oder das erfindungsgemäße Verfahren zur Herstellung organischer Halbleiter anwenden.

### Beispiele

### Beispiel 1: Nachbehandlung von 1,6-Bis(spiro-9,9'-bifluoren-2-yl)pyren

1,6-Bis(spiro-9,9'-bifluoren-2-yl)pyren wurde nach Standardmethoden durch Suzuki-Kupplung aus Spiro-9,9'-bifluoren-2-boronsäure und 1,6-Dibrompyren dargestellt. 8.31 g (10 mmol) 1,6-Bis(spiro-9,9'-bifluoren-2-yl)pyren mit einer Reinheit größer 99.9 % nach HPLC und einen Bromgehalt von 120 ppm (bestimmt durch Neutronenaktivierung) wurden in 100 ml absolutem THF suspendiert. Die fahlgelbe Suspension wurde auf -78 °C abgekühlt und tropfenweise mit 10 ml (16 mmol) einer 1.6 M Lösung von *tert*-Butyllithium in Hexan versetzt, wobei eine Verfärbung der fahlgelben Suspension nach tiefgrün auftrat. Die Reaktionsmischung wurde weitere 6 h bei -78 °C nachgerührt. Anschließend wurde die Reaktionsmischung mit einem Gemisch aus 10 ml Methanol und 50 ml THF versetzt. Nach Erwärmen auf Raumtemperatur wurde die Reaktionsmischung vom Lösemittel befreit, der Rückstand wurde in einem Gemisch aus 100 ml Ethanol und 100 ml Wasser aufgenommen und 30 min. unter Rückfluss gerührt. Nach Erkalten wurde vom Feststoff abgesaugt. Dieser wurde dreimal mit je 50 ml eines Gemischs aus Ethanol und Wasser (1:1, v:v) und dreimal mit je 50 ml Ethanol gewaschen. Nach dem Trocknen wurde der fahlgelbe Feststoff noch zweimal aus NMP umkristallisiert und im Hochvakuum (p = 2 x 10⁻⁵ mbar, T = 420 °C) sublimiert. Die Reinheit war größer 99.9 % nach HPLC bei einem Bromgehalt von 8 ppm (bestimmt durch Neutronenaktivierung).

### Beispiel 2: OLED mit nachbehandeltem 1,6-Bis(spiro-9,9'-bifluoren-2-yl)pyren

Die Herstellung der OLEDs erfolgte nach einem allgemeinen Verfahren gemäß WO 04/058911. Der grundlegende Aufbau, die verwendeten Materialien und Schichtdicken, außer der emittierenden Schicht und der Elektronentransportschicht, waren zur besseren Vergleichbarkeit identisch. Dabei wurde in der Emissionsschicht, entweder als Reinschicht oder als Hostmaterial zusammen mit einem Dotanden, die Verbindung **H1** (aus Beispiel 1, Bromgehalt 8 ppm) eingesetzt. Im Vergleich dazu wurde auch dieselbe Verbindung eingesetzt, die nicht separat nachbehandelt wurde und deren Brom-Gehalt bei 120 ppm lag.
Analog dem o. g. allgemeinen Verfahren wurden OLEDs mit folgendem Aufbau erzeugt:

| | |
|---|---|
| Lochinjektionsschicht (HIL) | 80 nm PEDOT (aus Wasser aufgeschleudert; bezogen von H. C. Starck, Goslar, Deutschland; Poly(3,4-ethylendioxy-2,5-thiophen)) |
| Lochtransportschicht (HTM) | 20 nm NaphDATA (aufgedampft; bezogen von SynTec, Wolfen, Deutschland; 4,4',4"-Tris(N-1-naphthyl-N-phenyl-amino)-triphenylamin) |
| Lochtransportschicht (HTM) | 20 nm S-TAD (aufgedampft; hergestellt nach WO 99/12888; 2,2',7,7'-Tetrakis(diphenylamino)-spiro-9,9'-bifluoren) |
| Emissionschicht (EML) | siehe Tabelle 1 für Materialien, Konzentration und Schichtdicken |
| Elektronenleiter (ETL) | 20 nm AlQ₃ (aufgedampft; bezogen von SynTec, Tris(chinolinato)aluminium(III); nicht in allen Fällen verwendet) |
| Ba-Al (Kathode) | 3 nm Ba, darauf 150 nm Al. |

Diese OLEDs wurden standardmäßig charakterisiert; hierfür wurden die Elektrolumineszenzspektren, die Effizienz (gemessen in cd/A), die Betriebsspannung und die Lebensdauer bestimmt. Als Lebensdauer wird die Zeit definiert, nach der die Anfangshelligkeit der OLED bei einer konstanten Stromdichte von 10 mA/cm² auf die Hälfte gesunken ist.

In Tabelle 1 sind die Ergebnisse einiger OLEDs (Beispiele 3 bis 5) zusammengefasst, wobei jeweils die Zusammensetzung der EML inklusive der Schichtdicke mit aufgeführt ist. Die EMLs enthalten als emittierende Materialien entweder reines 1,6-Bis(spiro-9,9'-bifluoren-2-yl)pyren (Host **H1**) oder den Dotanden **D1** (synthetisiert gemäß DE 102004031000.9) dotiert in 1,6-Bis(spiro-9,9'-bifluoren-2-yl)pyren (Host **H1**). Als Vergleichsbeispiele dienen OLEDs, die in der emittierenden Schicht 1,6-Bis(spiro-9,9'-bifluoren-2-yl)pyren, das nicht nachbehandelt wurde, gemäß dem Stand der Technik enthalten.
Zur besseren Übersichtlichkeit sind die entsprechenden Strukturformeln von 1,6-Bis(spiro-9,9'-bifluoren-2-yl)pyren (Host **H1** aus Beispiel 1) und des Dotanden **D1** im Folgenden dargestellt:

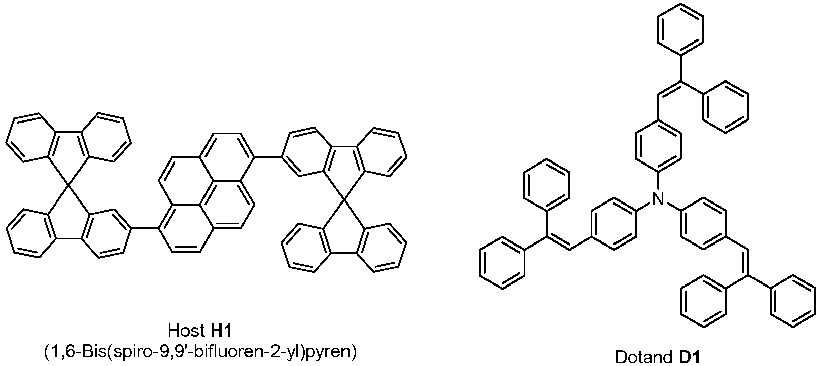

**Tabelle 1**

| Beispiel | EML | ETL | Max Effizienz [cd/A] | Spannung [V bei 100cd/m² | CIE x, y | Lebensdauer [h] |
|---|---|---|---|---|---|---|
| Beispiel 3a (nachbehandelt) | **H1** (30 nm) | AlQ₃ (20 nm) | 3.7 | 5.3 | x=0.17; y=0.22 | 1900 |
| Beispiel 3b (Vergleich) | **H1** (30 nm) | AlQ₃ (20 nm) | 3.7 | 5.4 | x=0.17; y=0.22 | 1400 |
| Beispiel 4a (nachbehandelt) | **H1** (40 nm) | | 3.4 | 5.6 | x=0.16; y=0.18 | 700 |
| Beispiel 4b (Vergleich) | **H1** (40 nm) | | 3.5 | 5.7 | x=0.16; y=0.18 | 450 |
| Beispiel 5a (nachbehandelt) | **H1: D1 (5%)** (30 nm) | AlQ₃ (20 nm) | 5.6 | 5.4 | x=0.17; y=0.31 | 7500 |
| Beispiel 5b (Vergleich) | **H1:D1** (5%) (30 nm) | AlQ₃ (20 nm) | 5.5 | 5.5 | x=0.17; y=0.31 | 5400 |

### Beispiel 6: Nachbehandlung des Polymers P1

Das Polymer **P1** wurde nach Standardmethoden durch Suzuki-Kupplung (WO 03/048225) synthetisiert aus 50 mol% **M1**, 30 mol% **M2**, 10 mol% **M3** und 10 mol% **M4** unter Zusatz von 0.8 mol% des Endcappers **E1.**
5.05 g (8 mmol) **P1** mit einem Molekulargewicht von M_{w} = 280.000 g/mol (nach GPC gegen Polystyrol-Standard) und einen Bromgehalt von 775 ppm (bestimmt durch Neutronenaktivierung) wurden in 80 ml Toluol/Dioxan 1:1 gelöst. Das vollständig gelöste Polymer wurde mit Endcapper **E2** und mit einer Lösung aus 4.05 g Kaliumphosphat Hydrat in 40 ml H₂O versetzt und sorgfältig entgast. Anschließend wurde der Katalysator (0.2 % Pd(OAc)₂ und 1.2 % P(o-tol)₃) zugesetzt und die Reaktionmischung 4 h unter Rückfluss erhitzt. Die Lösung wurde auf 60 °C abgekühlt und mit 40 ml einer 10 %igen Natrium-Thiocarbamat-Lösung versetzt. Die so erhaltene Mischung wurde weitere 3 h bei 60 °C gerührt. Die Lösung wurde auf Raumtemperatur abgekühlt, die Phasen getrennt und die organische Phase dreimal mit H₂O gewaschen. Das Polymer wurde durch Ausfällen aus Methanol isoliert und durch zweimaliges Umfällen aus THF/Methanol gereinigt. Der Bromgehalt des nachbehandelten Polymers betrug 15 ppm (bestimmt durch Neutronenaktivierung).

Analog dazu wurden weitere Polymere synthetisiert und analog zur Vorschrift oben nachbehandelt. Die Zusammensetzung der Polymere ist in Tabelle 2 angegeben. Der Übersichtlichkeit halber sind die verwendeten Monomere im Folgenden abgebildet:

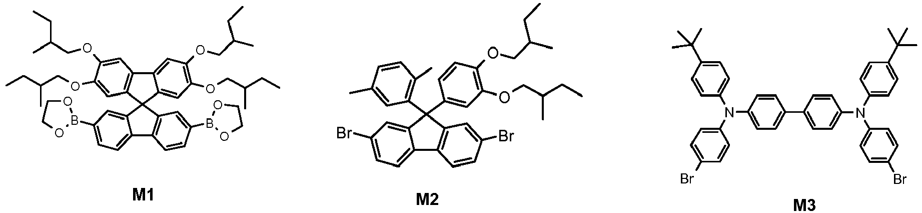

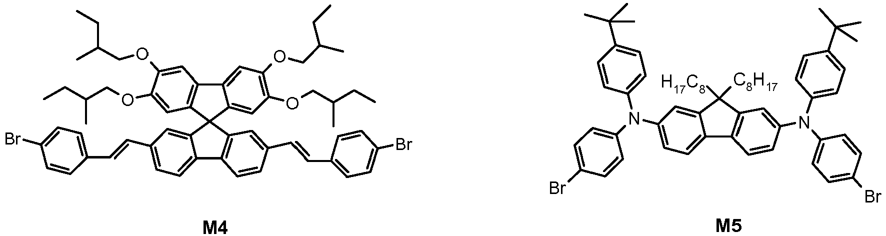

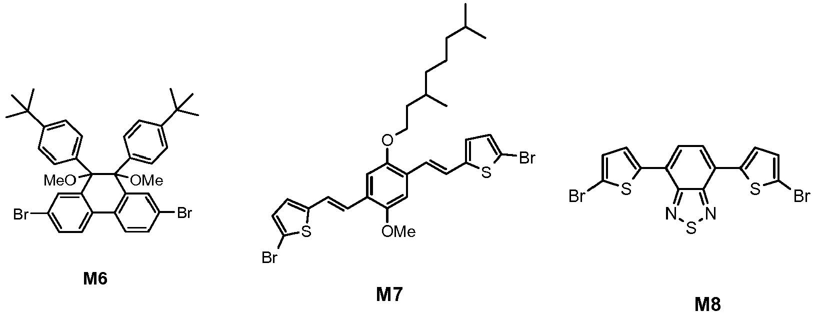

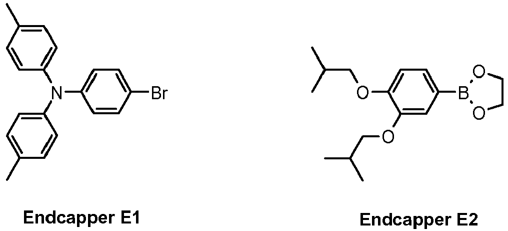

**Tabelle 2: Zusammensetzungen der Polymere**

| | **M1** | **M2** | **M3** | **M4** | **M5** | **M6** | **M7** | **M8** |
|---|---|---|---|---|---|---|---|---|
| **P1** | 50 | 30 | 10 | 10 | | | | |
| **P2** | 50 | 30 | 10 | 10 | | | | |
| **P3** | 50 | 39.88 | | | 10 | | 0.1 | 0.02 |
| **P4** | 50 | | | | 10 | 40 | | |

### Beispiel 7: Herstellung der PLEDs

Die Polymere wurden für einen Einsatz in PLEDs untersucht. Die PLEDs waren jeweils Zweischichtsysteme, d. h. Substrat//ITO//PEDOT//Polymer//Kathode. PEDOT ist ein Polythiophen-Derivat (Baytron P, von H. C. Stark, Goslar). Dabei betrug die Schichtdicke der PEDOT-Schicht und der Polymerschicht jeweils 80 nm. Als Kathode wurde in allen Fällen Ba/Ag (Aldrich) verwendet. Wie PLEDs dargestellt werden können, ist in WO 04/037887 und der darin zitierten Literatur ausführlich beschrieben.

### Beispiel 8: Device-Ergebnisse mit den Polymeren P1 bis P4

Die Ergebnisse, die bei Verwendung der Polymere **P1** bis **P4**, die gemäß der oben genannten Vorschrift nachbehandelt wurden, in PLEDs erhalten wurden, sind in Tabelle 3 zusammengefasst. Ebenso aufgeführt sind die Elektrolumineszenz-Ergebnisse, die unter Verwendung der nicht nachbehandelten Polymere erhalten wurden.

Wie man deutlich sieht, sind die erfindungsgemäßen Polymere, die einen geringeren Brom-Gehalt aufweisen, in der Elektrolumineszenz deutlich besser als Polymere mit einem höheren Brom-Gehalt gemäß dem Stand der Technik, insbesondere in der Lebensdauer, aber auch in der Effizienz.

**Tabelle 3: Device-Beispiele mit den Polymeren P1 bis P4**

| Polymer | Vor der Nachbehandlung | | | | Nach der Nachbehandlung | | | |
|---|---|---|---|---|---|---|---|---|
| | Bromgehalt [ppm] | Max. Eff [cd/A] | Lebensdauer [h] | U@ 100 cd/m² [V] | Bromgehalt [ppm] | Max. Eff [cd/A] | Lebensdauer [h] | U@ 100 cd/m² [V] |
| **P1** | 775 | 4.60 | 16 | 4.03 | 14.2 | 3.80 | 1200 | 3.88 |
| **P2** | 282 | 3.90 | 264 | 3.42 | 10.9 | 4.61 | 2300 | 3.43 |
| **P3** | 20.5 | 2.90 | 590 | 4.54 | 2.63 | 3.27 | 900 | 4.55 |
| **P4** | 413 | 5.56 | 1620 | 4.95 | 14.7 | 5.79 | 3100 | 4.90 |

### Beispiel 9: Ergebnisse bei mehrfacher Nachbehandlung

Das Polymer **P4** wurde noch weitere drei Male mit Endcapper **E2** analog zu Beispiel 6 behandelt. Nach jeder Nachbehandlung wurde der Bromgehalt bestimmt und die Polymere wurden nach jeder Nachbehandlung in einer PLED getestet. Die Ergebnisse, die mit diesem Polymer erhalten wurden, sind in Tabelle 4 zusammengefasst. Man sieht, dass durch jeden Nachbehandlungsschritt der Bromgehalt im Polymer weiter sinkt und schließlich bei einem Wert von weniger als 0.1 ppm liegt. Parallel dazu steigt die Effizienz und vor allem die Lebensdauer signifikant an.

**Tabelle 4: Ergebnisse mit mehrfach nachbehandeltem Polymer P4**

| | Unbehandelt | 1. Behandlung | 2. Behandlung | 3. Behandlung | 4. Behandlung |
|---|---|---|---|---|---|
| Br-Gehalt | 413 ppm | 14.7 ppm | 2.1 ppm | 0.3 ppm | < 0.1 ppm |
| Max. Eff. | 5.56 cd/A | 5.79 cd/A | 5.84 cd/A | 5.84 cd/A | 5.86 cd/A |
| Lebensdauer | 1620 h | 3100 h | 4200 h | 5700 h | > 6000 h |
| | 4.95 V | 4.90 V | 4.88 V | 4.86 V | 4.86 V |

## Patentansprüche

1. Elektronische Vorrichtung enthaltend mindestens einen organischen Halbleiter, der durch eine Reaktion erhalten wurde, an der mindestens ein reaktives Halogen beteiligt war, **dadurch gekennzeichnet, dass** der Gehalt an dem Halogen, welches an der Reaktion beteiligt war, im organischen Halbleiter kleiner als 20 ppm ist, und dass der Gehalt an den Halogenen Fluor, Chlor, Brom und Iod im organischen Halbleiter jeweils kleiner als 20 ppm ist, mit der Maßgabe, dass diese Begrenzung für Fluor nur dann gilt, wenn Fluor nicht konstituierender Bestandteil der chemischen Struktur des organischen Halbleiters ist;
mit der Maßgabe, dass der organische Halbleiter kein Polythiophen ist, das durch eine Reaktion erhalten wurde, an der Brom als reaktives Halogen beteiligt war, und das einen Gehalt an Brom von weniger als 20 ppm aufweist.

2. Elektronische Vorrichtung gemäß Anspruch 1, ausgewählt aus der Gruppe bestehend aus organischen oder polymeren Leuchtdioden, organischen Feld-Effekt-Transistoren, organischen Dünnfilmtransistoren, organischen integrierten Schaltungen, organischen Solarzellen, organischen Feld-Quench-Devices, organischen lichtemittierende Transistoren, lichtemittierenden elektrochemischen Zellen oder organischen Laserdioden.

3. Elektronische Vorrichtung gemäß einem oder mehreren der Ansprüche 1 oder 2, **dadurch gekennzeichnet, dass** der organische Halbleiter polymer ist.

4. Elektronische Vorrichtung gemäß Anspruch 3, **dadurch gekennzeichnet, dass** es sich um Poly-p-arylen-vinylene (PAVs), Polyfluorene (PFs), Poly-spirobifluorene (PSFs), Poly-paraphenylene (PPPs) oder -biphenylene, Poly-dihydrophenanthrene (PDHPs), Poly-trans-indenofluorene oder Poly-cis-indenofluorene (PIF), Polythiophene (PTs), Polypyridine (PPys), Polypyrrole, Poly-phenanthrene, phosphoreszierende Polymere, vernetzbare Polymere, Poly-vinyl-carbazole (PVKs), Triarylaminpolymere oder Copolymere, die Struktureinheiten aus zwei oder mehr dieser Klassen aufweisen, handelt.

5. Elektronische Vorrichtung gemäß einem oder mehreren der Ansprüche 1 oder 2, **dadurch gekennzeichnet, dass** der organische Halbleiter niedermolekular und organisch oder metallorganisch ist.

6. Elektronische Vorrichtung gemäß einem oder mehreren der Ansprüche 1 oder 2, **dadurch gekennzeichnet, dass** der organische Halbleiter dendritisch und organisch oder metallorganisch ist.

7. Elektronische Vorrichtung gemäß einem oder mehreren der Ansprüche 1 bis 6, **dadurch gekennzeichnet, dass** der Gehalt an Schwefel im organischen Halbleiter kleiner als 20 ppm ist.

8. Elektronische Vorrichtung gemäß einem oder mehreren der Ansprüche 1 bis 7, **dadurch gekennzeichnet, dass** der Gehalt an Phosphor im organischen Halbleiter kleiner als 20 ppm ist.

9. Elektronische Vorrichtung gemäß einem oder mehreren der Ansprüche 1 bis 8, **dadurch gekennzeichnet, dass** der Gehalt an Silicium im organischen Halbleiter kleiner als 20 ppm ist.

10. Elektronische Vorrichtung gemäß einem oder mehreren der Ansprüche 1 bis 9, **dadurch gekennzeichnet, dass** der Gehalt an Bor im organischen Halbleiter kleiner als 20 ppm ist.

11. Verwendung eines organischen Halbleiters, der durch eine Reaktion erhalten wurde, an der mindestens ein reaktives Halogen beteiligt war, mit einem Gehalt an dem Halogen, welches an der Reaktion beteiligt war, kleiner als 20 ppm in einer elektronischen Vorrichtung, und dass der Gehalt an den Halogenen Fluor, Chlor, Brom und Iod im organischen Halbleiter jeweils kleiner als 20 ppm ist, mit der Maßgabe, dass diese Begrenzung für Fluor nur dann gilt, wenn Fluor nicht konstituierender Bestandteil der chemischen Struktur des organischen Halbleiters ist;
mit der Maßgabe, dass der organische Halbleiter kein Polythiophen ist, das durch eine Reaktion erhalten wurde, an der Brom als reaktives Halogen beteiligt war, und das einen Gehalt an Brom von weniger als 20 ppm aufweist.

12. Verfahren zur Herstellung eines organischen Halbleiters mit einem Gehalt an den Halogenen Fluor, Chlor, Brom oder Iod jeweils kleiner als 20 ppm, mit der Maßgabe, dass diese Begrenzung für Fluor nur dann gilt, wenn Fluor nicht konstituierender Bestandteil der chemischen Struktur des organischen Halbleiters ist, umfassend die folgenden Schritte:
a) Herstellung des organischen Halbleiters mittels einer Reaktion mit einem reaktiven Halogen, insbesondere Kupplung gemäß Suzuki, Kupplung gemäß Stille, Kupplung gemäß Yamamoto, Kupplung gemäß Heck, Kupplung gemäß Hartwig-Buchwald, Kupplung gemäß Sonogashira, Kupplung gemäß Negishi, Kupplung gemäß Hiyama oder Gilch-Reaktion;
b) gegebenenfalls Isolierung des organischen Halbleiters aus a);
c) Nachbehandlung des organischen Halbleiters derart, dass der Gehalt an den Halogenen im organischen Halbleiter reduziert wird;
mit der Maßgabe, dass die Nachbehandlung nicht mittels Behandeln mit einer metallorganischen Verbindung in einem inerten Lösemittel und anschließendem Isolieren durchgeführt wird, wenn es sich bei dem Verfahrensprodukt um ein Polythiophen mit einem Bromgehalt von weniger als 20 ppm handelt.

13. Verfahren gemäß Anspruch 12, **dadurch gekennzeichnet, dass** der organische Halbleiter als Feststoff isoliert und die Nachbehandlung (Schritt c)) in einem separaten Reaktionsschritt durchgeführt wird.

14. Verfahren gemäß Anspruch 12 und/oder 13, **dadurch gekennzeichnet, dass** die Nachbehandlung (Schritt c)) mit einem Reduktionsmittel, das Halogene reduziert und gegen Wasserstoff austauscht, durchgeführt wird.

15. Verfahren gemäß Anspruch 14, **dadurch gekennzeichnet, dass** als Reduktionsmittel einfache Hydride, ternäre Hydride, Alane, Borane, einfache Übergangsmetallhydride, komplexe Übergangsmetallhydride oder Hauptgruppen-Element-Hydride, gegebenenfalls in Kombination mit einer Lewis-Säure, eingesetzt werden.

16. Verfahren gemäß Anspruch 14, **dadurch gekennzeichnet, dass** als Reduktionsmittel eine Hydridquelle oder Wasserstoff, gegebenenfalls unter Druck, unter Einsatz homogener oder heterogener Übergangsmetallkatalysatoren verwendet werden.

17. Verfahren gemäß Anspruch 12 und/oder 13, **dadurch gekennzeichnet, dass** die Nachbehandlung (Schritt c)) mit metallorganischen Reagenzien, die Transmetallierung eingehen, oder mit reaktiven Metallen, die das Halogen gegen ein Metallatom austauschen, erfolgt.

18. Verfahren gemäß Anspruch 17, **dadurch gekennzeichnet, dass** die metallierte Zwischenstufe durch Hydrolyse mit einer protischen Verbindung in die unsubstituierte Verbindung umgesetzt wird oder durch eine metallkatalysierte Kupplungsreaktion mit einer Arylbromid oder -iodid in eine arylsubstituierte Verbindung umgesetzt wird.

19. Verfahren gemäß Anspruch 12 und/oder 13, **dadurch gekennzeichnet, dass** die Nachbehandlung (Schritt c)) durch eine Kupplung unter Übergangsmetallkatalyse mit einer Vinyl-H-Verbindung, mit einem Aryl-Boronsäurederivat, mit einem Aryl-Zinnderivat, mit einem aromatischen Amin, mit einer Acetylen-H-Verbindung, mit einer Arylsilyl-Verbindung oder mit einem Arylhalogenid erfolgt.

20. Verfahren gemäß einem oder mehreren der Ansprüche 12 bis 19, **dadurch gekennzeichnet, dass** mehrere gleiche oder verschiedene Nachbehandlungsschritte (Schritte c)) nacheinander durchgeführt werden.

21. Lösungen enthaltend einen oder mehrere organische Halbleiter, welche nach einem Verfahren gemäß einem oder mehreren der Ansprüche 12 bis 20 erhalten wurden, in einem oder mehreren Lösemitteln.

## Claims

1. Electronic device containing at least one organic semiconductor which has been obtained by a reaction involving at least one reactive halogen, **characterised in that** the content of the halogen involved in the reaction in the organic semiconductor is less than 20 ppm, and **in that** the content of the halogens fluorine, chlorine, bromine and iodine in the organic semiconductor is in each case less than 20 ppm, with the proviso that this limit applies to fluorine only if fluorine is not a constituent part of the chemical structure of the organic semiconductor; with the proviso that the organic semiconductor is not a polythiophene which has been obtained by a reaction involving bromine as reactive halogen, and which has a bromine content of less than 20 ppm.

2. Electronic device according to Claim 1, selected from the group consisting of organic or polymeric light-emitting diodes, organic field-effect transistors, organic thin-film transistors, organic integrated circuits, organic solar cells, organic field-quench devices, organic light-emitting transistors, light-emitting electrochemical cells or organic laser diodes.

3. Electronic device according to one or more of Claims 1 or 2, **characterised in that** the organic semiconductor is polymeric.

4. Electronic device according to Claim 3, **characterised in that** it comprises poly-p-arylenevinylenes (PAVs), polyfluorenes (PFs), polyspirobifluorenes (PSFs), poly-para-phenylenes (PPPs) or -biphenylenes, polydihydrophenanthrenes (PDHPs), poly-trans-indenofluorenes or poly-cis-indenofluorenes (PIFs), polythiophenes (PTs), polypyridines (PPys), polypyrroles, polyphenanthrenes, phosphorescent polymers, crosslinkable polymers, polyvinylcarbazoles (PVKs), triarylamine polymers or copolymers which have structural units from two or more of these classes.

5. Electronic device according to one or more of Claims 1 or 2, **characterised in that** the organic semiconductor is of low molecular weight and is organic or organometallic.

6. Electronic device according to one or more of Claims 1 or 2, **characterised in that** the organic semiconductor is dendritic and organic or organometallic.

7. Electronic device according to one or more of Claims 1 to 6, **characterised in that** the sulfur content in the organic semiconductor is less than 20 ppm.

8. Electronic device according to one or more of Claims 1 to 7, **characterised in that** the phosphorus content in the organic semiconductor is less than 20 ppm.

9. Electronic device according to one or more of Claims 1 to 8, **characterised in that** the silicon content in the organic semiconductor is less than 20 ppm.

10. Electronic device according to one or more of Claims 1 to 9, **characterised in that** the boron content in the organic semiconductor is less than 20 ppm.

11. Use of an organic semiconductor which has been obtained by a reaction involving at least one reactive halogen, having a content of the halogen involved in the reaction of less than 20 ppm in an electronic device, and the content of the halogens fluorine, chlorine, bromine and iodine in the organic semiconductor is in each case less than 20 ppm, with the proviso that this limit applies to fluorine only if fluorine is not a constituent part of the chemical structure of the organic semiconductor;
with the proviso that the organic semiconductor is not a polythiophene which has been obtained by a reaction involving bromine as reactive halogen, and which has a bromine content of less than 20 ppm.

12. Process for the preparation of an organic semiconductor having a content of the halogens fluorine, chlorine, bromine and iodine of in each case less than 20 ppm, with the proviso that this limit applies to fluorine only if fluorine is not a constituent part of the chemical structure of the organic semiconductor, comprising the following steps:
a) preparation of the organic semiconductor by means of a reaction with a reactive halogen, in particular Suzuki coupling, Stille coupling, Yamamoto coupling, Heck coupling, Hartwig-Buchwald coupling, Sonogashira coupling, Negishi coupling, Hyama coupling or Gilch reaction;
b) optionally isolation of the organic semiconductor from a);
c) aftertreatment of the organic semiconductor in such a way that the content of the halogens in the organic semiconductor is reduced;
with the proviso that the aftertreatment is not carried out by means of treatment with an organometallic compound in an inert solvent and subsequent isolation if the process product is a polythiophene having a bromine content of less than 20 ppm.

13. Process according to Claim 12, **characterised in that** the organic semiconductor is isolated as a solid and the aftertreatment (step c)) is carried out in a separate reaction step.

14. Process according to Claim 12 and/or 13, **characterised in that** the aftertreatment (step c)) is carried out with a reducing agent which reduces halogens and replaces them with hydrogen.

15. Process according to Claim 14, **characterised in that** the reducing agents employed are simple hydrides, ternary hydrides, alanes, boranes, simple transition-metal hydrides, complex transition-metal hydrides or main-group element hydrides, optionally in combination with a Lewis acid.

16. Process according to Claim 14, **characterised in that** the reducing agents used are a hydride source or hydrogen, optionally under pressure, with use of homogeneous or heterogeneous transition-metal catalysts.

17. Process according to Claim 12 and/or 13, **characterised in that** the aftertreatment (step c)) is carried out with organometallic reagents which undergo transmetallation or with reactive metals which replace the halogen with a metal atom.

18. Process according to Claim 17, **characterised in that** the metallated intermediate is converted into the unsubstituted compound by hydrolysis using a protic compound or converted into an aryl-substituted compound by a metal-catalyzed coupling reaction with an aryl bromide or iodide.

19. Process according to Claim 12 and/or 13, **characterised in that** the aftertreatment (step c)) is carried out by a coupling, with transition-metal catalysis, to a vinyl-H compound, to an arylboronic acid derivative, to an aryltin derivative, to an aromatic amine, to an acetylene-H compound, to an arylsilyl compound or to an aryl halide.

20. Process according to one or more of Claims 12 to 19, **characterised in that** a plurality of identical or different aftertreatment steps (steps c)) are carried out one after the other.

21. Solutions comprising one or more organic semiconductors which have been obtained by a process according to one or more of Claims 12 to 20 in one or more solvents.

## Revendications

1. Dispositif électronique contenant au moins un semiconducteur organique qui a été obtenu au moyen d'une réaction qui met en jeu au moins un halogène réactif, **caractérisé en ce que** la teneur de l'halogène qui est mis en jeu lors de la réaction dans le semiconducteur organique est inférieure à 20 ppm, et **en ce que** la teneur en halogènes que sont le fluor, le chlore, le brome et l'iode dans le semiconducteur organique est dans chaque cas inférieure à 20 ppm, étant entendu que cette limite s'applique au fluor seulement si le fluor n'est pas une partie constitutive de la structure chimique du semiconducteur organique ; étant entendu que le semiconducteur organique n'est pas un polythiophène qui a été obtenu au moyen d'une réaction qui met en jeu du brome en tant qu'halogène réactif, et qui présente une teneur en brome inférieure à 20 ppm.

2. Dispositif électronique selon la revendication 1, sélectionné parmi le groupe qui est constitué par les diodes à émission de lumière organiques ou polymériques, les transistors à effet de champ organiques, les transistors à film mince organiques, les circuits intégrés organiques, les cellules solaires organiques, les dispositifs à extinction de champ organiques, les transistors à émission de lumière organiques, les cellules électrochimiques à émission de lumière ou les diodes laser organiques.

3. Dispositif électronique selon une ou plusieurs des revendications 1 ou 2, **caractérisé en ce que** le semiconducteur organique est polymérique.

4. Dispositif électronique selon la revendication 3, **caractérisé en ce qu'**il comprend des poly-p-arylènevinylènes (PAV), des polyfluorènes (PF), des polyspirobifluorènes (PSF), des poly-para-phénylènes (PPP) ou -biphénylènes, des polydihydrophénanthrènes (PDHP), des poly-trans-indénofluorènes ou des poly-cis-indénofluorènes (PIF), des polythiophènes (PT), des polypyridines (PPy), des polypyrroles, des polyphénanthrènes, des polymères phosphorescents, des polymères pouvant être réticulés, des polyvinylcarbazoles (PVK), des polymères ou des copolymères triarylamine qui comportent des unités structurelles qui sont issues de deux ou plus de ces classes.

5. Dispositif électronique selon une ou plusieurs des revendications 1 ou 2, **caractérisé en ce que** le semiconducteur organique est d'un poids moléculaire faible et est organique ou organométallique.

6. Dispositif électronique selon une ou plusieurs des revendications 1 ou 2, **caractérisé en ce que** le semiconducteur organique est dendritique et organique ou organométallique.

7. Dispositif électronique selon une ou plusieurs des revendications 1 à 6, **caractérisé en ce que** la teneur en soufre dans le semiconducteur organique est inférieure à 20 ppm.

8. Dispositif électronique selon une ou plusieurs des revendications 1 à 7, **caractérisé en ce que** la teneur en phosphore dans le semiconducteur organique est inférieure à 20 ppm.

9. Dispositif électronique selon une ou plusieurs des revendications 1 à 8, **caractérisé en ce que** la teneur en silicium dans le semiconducteur organique est inférieure à 20 ppm.

10. Dispositif électronique selon une ou plusieurs des revendications 1 à 9, **caractérisé en ce que** la teneur en bore dans le semiconducteur organique est inférieure à 20 ppm.

11. Utilisation d'un semiconducteur organique qui a été obtenu au moyen d'une réaction qui met en jeu au moins un halogène réactif, présentant une teneur en l'halogène qui est mis en jeu au niveau de la réaction inférieure à 20 ppm dans un dispositif électronique, et la teneur en halogènes que sont le fluor, le chlore, le brome et l'iode dans le semiconducteur organique est dans chaque cas inférieure à 20 ppm, étant entendu que cette limite s'applique au fluor seulement si le fluor n'est pas une partie constitutive de la structure chimique du semiconducteur organique,
étant entendu que le semiconducteur organique n'est pas un polythiophène qui a été obtenu au moyen d'une réaction qui met en jeu le brome en tant qu'halogène réactif, et qui présente une teneur en brome inférieure à 20 ppm.

12. Procédé pour la préparation d'un semiconducteur organique qui présente une teneur en halogènes que sont le fluor, le chlore, le brome et l'iode qui est dans chaque cas inférieure à 20 ppm, étant entendu que cette limite s'applique au fluor seulement si le fluor n'est pas une partie constitutive de la structure chimique du semiconducteur organique, comprenant les étapes qui suivent :
a) la préparation du semiconducteur organique au moyen d'une réaction avec un halogène réactif, en particulier un couplage de Suzuki, un couplage de Stille, un couplage de Yamamoto, un couplage de Heck, un couplage de Hartwig-Buchwald, un couplage de Sonogashira, un couplage de Negishi, un couplage de Hyama ou une réaction de Gilch ;
b) en option, l'isolement du semiconducteur organique issu de a) ;
c) le post-traitement du semiconducteur organique de telle sorte que la teneur en halogènes dans le semiconducteur organique soit réduite ;
étant entendu que le post-traitement n'est pas mis en œuvre au moyen d'un traitement à l'aide d'un composé organométallique dans un solvant inerte et au moyen d'un isolement subséquent si le produit de processus est un polythiophène qui présente une teneur en brome inférieure à 20 ppm.

13. Procédé selon la revendication 12, **caractérisé en ce que** le semiconducteur organique est isolé en tant que solide et le post-traitement (étape c)) est mis en œuvre lors d'une étape de réaction séparée.

14. Procédé selon la revendication 12 et/ou 13, **caractérisé en ce que** le post-traitement (étape c)) est mis en œuvre à l'aide d'un agent de réduction qui réduit les halogènes et qui les remplace par de l'hydrogène.

15. Procédé selon la revendication 14, **caractérisé en ce que** les agents de réduction qui sont utilisés sont les hydrures simples, les hydrures ternaires, les alanes, les boranes, les hydrures simples de métaux de transition, les hydrures complexes de métaux de transition ou les hydrures d'éléments de groupes principaux, en option en combinaison avec un acide de Lewis.

16. Procédé selon la revendication 14, **caractérisé en ce que** les agents de réduction qui sont utilisés sont une source d'hydrure ou de l'hydrogène, en option sous pression, avec l'utilisation de catalyseurs de métaux de transition homogènes ou hétérogènes.

17. Procédé selon la revendication 12 et/ou 13, **caractérisé en ce que** le post-traitement (étape c)) est mis en œuvre à l'aide de réactifs organométalliques qui subissent une transmétallation ou à l'aide de métaux réactifs qui remplacent l'halogène par un atome de métal.

18. Procédé selon la revendication 17, **caractérisé en ce que** le produit intermédiaire métallaté est converti selon le composé non substitué par hydrolyse en utilisant un composé protique ou est converti selon un composé à substitution aryle au moyen d'une réaction de couplage catalysée par métal avec un bromure ou iodure d'aryle.

19. Procédé selon la revendication 12 et/ou 13, **caractérisé en ce que** le post-traitement (étape c)) est mis en œuvre au moyen d'un couplage, à l'aide d'une catalyse par métaux de transition, sur un composé vinyle-H, sur un dérivé d'acide arylboronique, sur un dérivé d'aryltine, sur un amine aromatique, sur un composé acétylène-H, sur un composé arylsilyle ou sur un halogénure d'aryle.

20. Procédé selon une ou plusieurs des revendications 12 à 19, **caractérisé en ce qu'**une pluralité d'étapes de post-traitement identiques ou différentes (étapes c)) sont mises en œuvre les unes après les autres.

21. Solutions comprenant un ou plusieurs semiconducteur(s) organique(s) qui a/ont été obtenu(s) par un procédé selon une ou plusieurs des revendications 12 à 20 dans un seul ou plusieurs solvant(s).
